(19) Europäisches Patentamt

European Patent Office

Office européen des brevets

(11) Veröffentlichungsnummer: **0 350 850**

**A2**

(12) **EUROPÄISCHE PATENTANMELDUNG**

(21) Anmeldenummer: **89112623.7**

(22) Anmeldetag: **11.07.89**

(51) Int. Cl.⁴: **H05K 13/04**

(30) Priorität: **14.07.88 DE 3823836**

(43) Veröffentlichungstag der Anmeldung:
**17.01.90 Patentblatt 90/03**

(84) Benannte Vertragsstaaten:
**CH DE FR GB IT LI NL SE**

(71) Anmelder: **ROHDE & SCHWARZ ENGINEERING AND SALES GMBH**
**Tassiloplatz 7**
**D-8000 München 80(DE)**

(72) Erfinder: **Domm, Martin, Dipl.-Ing.**
**Trollinger Weg 14**
**D-7129 Ilsfeld(DE)**

(74) Vertreter: **Graf, Walter, Dipl.-Ing.**
**Sckellstrasse 1**
**D-8000 München 80(DE)**

(54) **Vorrichtung zum maschinellen Bestücken von Leiterplatten mit Bauelementen.**

(57) Bei einer Vorrichtung zum maschinellen Bestükken von Leiterplatten mit Bauelementen mittels eines Industrieroboters ist die Vermessungseinrichtung zum optischen Vermessen der Bauelemente in unmittelbarer Zuordnung zum Bewegungsbereich des vom Roboter erfaßten Bauelementes am äußeren Roboterarm angeordnet.

EP 0 350 850 A2

## Vorrichtung zum maschinellen Bestücken von Leiterplatten mit Bauelementen

Die Erfindung betrifft eine Vorrichtung laut Oberbegriff des Hauptanspruches.

Eine Vorrichtung dieser Art ist bekannt (EP-OS 0 234 904). Die hierbei als Vermessungseinrichtung verwendete Videokamera ist ortsfest neben dem Roboter angeordnet, der Roboterarm bringt das einzusetzende Bauelement zunächst von der Bereitstellungsposition über diese ortsfeste Videokamera, die Spitzen der Anschlußdrähte des Bauelementes werden hier von unten durch die Videokamera vermessen und das Meßergebnis wird mit dem Meßergebnis der Löcher der Leiterplatte verglichen, die durch eine gesonderte zweite Videokamera vermessen werden. Wenn hierbei keine Verbiegung der Anschlußdrähte festgestellt wird bewegt der Roboter das Bauelement weiter bis zur Bestückungsposition oberhalb der Leiterplatte und der Greifer des Roboters senkt dann das Bauelement nach unten auf die Leiterplatte ab und führt so die Anschlußdrähte des Bauelementes in die entsprechenden Löcher der Leiterplatte ein. Bei dieser bekannten Vorrichtung muß der Roboterarm auf seinem Weg von der Bereitstellungsposition zur Bestückungsposition einen Umweg über diese ortsfeste Vermessungseinrichtung vornehmen, der etwa 30 % der Taktzeit in Anspruch nimmt. Außerdem ist diese bekannte Vorrichtung mit der von unten her das Bauelement vermessenden Vermessungseinrichtung nicht für beliebige Bauelemente geeignet, sondern auf das Vermessen von elektronischen Bauelementen mit nach unten abstehenden Anschlußdrähten beschränkt.

Entsprechendes gilt für eine andere bekannte Vorrichtung dieser Art (DE-OS 35 46 216), bei welcher Chip-Träger mittels eines Vakuumhalters von einer Bereitstellungposition in die Bestückungsposition oberhalb einer Leiterplatte transportiert werden. Auch hier werden die Anschlußdrähte des Chips mittels einer Videokamera von unten vermessen. Damit eignet sich auch diese bekannte Vorrichtung wieder nur zum Einsetzen von Chip-Trägern, sie wäre infolge der Verwendung eines Vakuumhalters und infolge der Vermessung von unten nicht zum Einsetzen von anderen beispielsweise mechanischen Bauelementen geeignet.

Es ist Aufgabe der Erfindung, eine Vorrichtung zum maschinellen Bestücken von Leiterplatten zu schaffen, die ohne Verlust an Taktzeit für das Vermessen und Einsetzen beliebiger Bauelemente geeignet ist.

Diese Aufgabe wird ausgehend von einer Vorrichtung laut Oberbegriff des Hauptanspruches durch dessen kennzeichnende Merkmale gelöst. Vorteilhafte Weiterbildungen ergeben sich aus den Unteransprüchen.

Durch die erfindungsgemäße Anordnung der Vermessungseinrichtung unmittelbar am Roboterarm neben dem Greifer ist es möglich, das Bauelement von der Seite aus seitlich zu vermessen und zwar in zwei oder mehreren unterschiedlichen Winkeldrehstellungen. Damit können nicht nur Anschlußdrähte von elektronischen Bauelementen exakt vermessen werden, sondern auch beliebige andere elektrische oder mechanische Bauelemente, denn bei einer seitlichen Vermessung können beispielsweise auch Gewindegänge und die Geradheit einer einzusetzenden Schraube vermessen werden. Da beim Vermessen in unterschiedlichen Winkelstellungen, beispielsweise unter zwei um 90° gegeneinander versetzten Stellungen, unterschiedliche Vermessungsergebnisse ein und desselben Bauelements ermittelt werden, die abstehenden Anschlußdrähte eines elektronischen Bauelements also aus zwei verschiedenen Richtungen vermessen werden, kann aus diesen Meßergebnissen die Form des Bauelementes exakt errechnet werden, also beispielsweise die Lage der Anschlußdrähte des Bauelements. Dieses das Bauelement exakt beschreibende Meßergebnis braucht dann nur noch in die Steuereinrichtung für den Roboter eingegeben zu werden. Damit ist eine erfindungsgemäße Vorrichtung sehr universell verwendbar. Die Vermessung des Bauelementes von der Seite aus bringt außerdem noch den großen Vorteil mit sich, daß in den unterschiedlichen Winkelstellungen die Vermessung stets mit dem gleichen neutralen Hintergrund erfolgt und daher auch nicht die zusätzlichen Fehlereliminierungsmaßnahmen wie bei den bekannten Vorrichtungen nötig sind, bei denen die Vermessung der Bauelemente von unten erfolgt und daher durch spezielle Beleuchtungseinrichtungen dafür gesorgt werden muß, daß Fehlmessungen durch unruhigen oder bei verschiedenen Bauelementen unterschiedlichen Hintergrund vermieden werden. Besonders vorteilhaft ist es hierbei, die Lichtquelle unmittelbar gegenüber der Vermessungseinrichtung anzuordnen, so daß die optische Vermessungseinrichtung ein scharfes kontrastreiches seitliches Bild des zu vermessenden Bauelementes aufnimmt, das unabhängig von irgendwelchen Umgebungseinflüssen und Streulicht ist. Besonders vorteilhaft ist es hierbei, wenn eine Rotlichtquelle benutzt wird und der Vermessungseinrichtung, beispielsweise einer Videokamera, ein entsprechendes Rotlichtfilter zugeordnet wird, denn dadurch kann Streu-Tageslicht vollständig ausgeschaltet werden und es ist eine sehr exakte Vermessung des Bauelementes gewährleistet. Durch die unmittelbare Anbringung der Vermessungseinrichtung am Roboterarm neben dem Greifer wird außerdem ein Umweg zur Vermessung überflüssig und es werden etwa 30 % der zur Verfügung stehenden Robotertaktzeit eingespart, der Bestückungsvorgang kann also wesentlich schneller als mit den bisher bekannten Vorrichtungen durchgeführt werden.

Durch den Vermessungsvorgang während des Transportes des Bauelements vom Bereitstellungspunkt zum Bestückungspunkt kann ohne Taktzeitverlust das Bauelement aus verschiedenen Winkelstellungen vermessen werden, die Meßwerte können mit den Soll-Werten, die in einer Datenbank für die verschiedenen Bauelemente abgespeichert sind, verglichen werden, wenn das Meßergebnis innerhalb des vorgegebenen Toleranzbereiches liegt, kann das Bauelement unmittelbar in die Leiterplatte eingesetzt werden, wird eine Abweichung der Abmessungen des Bauelementes gegenüber den zulässigen Toleranzwerten festgestellt, so wird dieses Bauelement entweder als Ausschuß abgelegt oder zur Korrektur der festgestellten Fehler, beispielsweise zum Ausrichten der verbogenen Anschlußdrähte des Bauelements, einer entsprechenden gesonderten Ausrichtvorrichtung zugeführt. Die erfindungsgemäße Vorrichtung ist nicht nur zum Vermessen von Anschlußdrähten elektronischer Bauelemente geeignet, sondern auch zum Vermessen anderer Bauelemente wie Meßnadeln, Schrauben oder dgl., bei denen entsprechende Toleranzen eingehalten werden müssen. Als Vermessungseinrichtung ist insbesondere eine Videokamera mit zugehöriger Lichtquelle geeignet, es könnte für diesen Zweck jedoch auch ein Laser-Scanner verwendet werden. Die erfindungsgemäße Vorrichtung eignet sich für beliebige mehrachsige Industrieroboter, es muß nur dafür gesorgt werden, daß die Steuerbewegung des Roboterarms für den Transport der Bauelemente vom Bereitstellungspunkt zum Bestückungspunkt von der Steuerbewegung des das Bauelement erfassenden Greifers entkoppelt ist, d.h., daß die Verschiebung und/oder Verdrehung des Greifers unabhängig von der Steuerbewegung des übrigen Roboterarms so gesteuert werden kann, daß das Bauelement einerseits die gewünschten verschiedenen Winkelstellungen für die Vermessung und schließlich am Ende dieses Vermessungsvorgangs die richtige Bestückungsstellung einnimmt. Mit der erfindungsgemäßen Vorrichtung können auch entsprechende Korrekturbewegungen des Industrieroboters in Abhängigkeit von den Meßergebnissen durchgeführt werden.

Die Erfindung wird im folgenden anhand schematischer Zeichnungen an einem Ausführungsbeispiel näher erläutert.

Fig. 1 zeigt die Gesamtansicht einer erfindungsgemäßen Vorrichtung zum maschinellen Bestücken von Leiterplatten mit Bauelementen.

Fig. 2 zeigt Einzelheiten der hierbei verwendeten Vermessungseinrichtung.

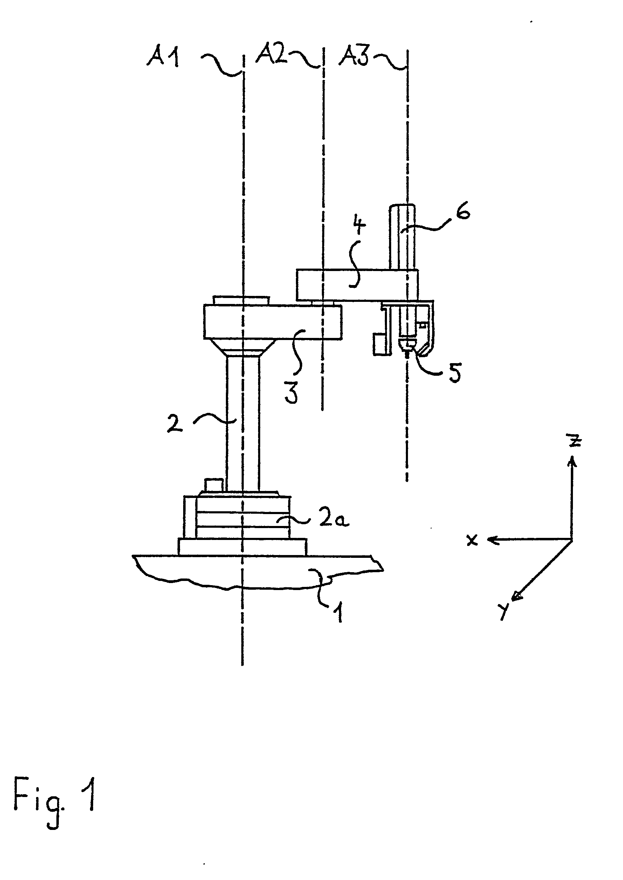

Fig. 1 zeigt einen dreiachsigen Industrieroboter handelsüblicher Art, beispielsweise einen sogenannten Scararoboter der Firma Adept-Technology. Dabei ist an einem auf einer Unterlage 1 aufgestellten Ständer 2 ein innerer Gelenkarm 3 um eine Achse $A_1$ schwenkbar gelagert. Ein äußerer Gelenkarm 4 ist um eine Achse $A_2$ schwenkbar gelagert. An diesem äußeren Gelenkarm 4 ist ein Greifer 5 angeordnet, der um eine Achse $A_3$ des Gelenkarmes drehbar und entlang dieser Achse in z-Richtung verschiebbar ist. Aufgrund dieser Anordnung kann der Greifer 5 in einer die beiden Koordinatenrichtungen x,y enthaltenden Ebene zum Bestückungspunkt bewegt werden, um seine eigene Achse soweit verdreht werden, daß er die für den Bestückungsvorgang erforderliche Winkellage einnimmt, und zum Einsetzen des Bauelementes 11 in die nicht dargestellte Leiterplatte in z-Richtung abgesenkt werden. Zum Antrieb des Greifers 5 in z-Richtung und zum Verdrehen um seine Achse sowie zum Öffnen und Schließen des Greifers dient eine am äußeren Gelenkarm 4 angeordnete Antriebseinheit 6. Alle Bewegungen des Industrieroboters und des Greifers 5 werden in bekannter Weise von einer beispielsweise im Fuß 2a des Ständers 2 untergebrachten programmierbaren Steuereinheit gesteuert.

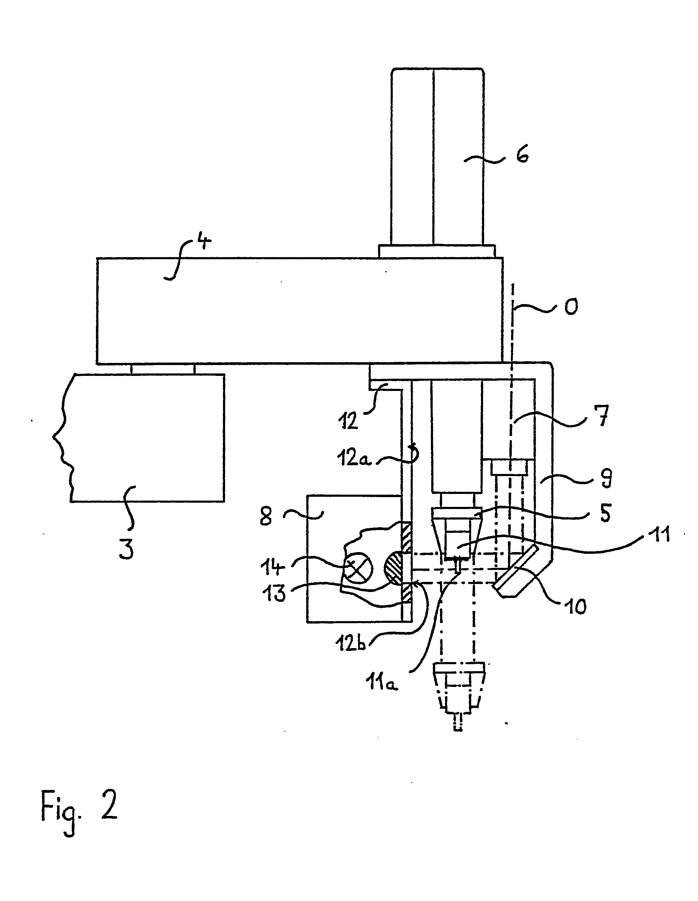

Wie insbesondere aus Fig. 2 ersichtlich ist, sind am äußeren Gelenkarm 4 eine Videokamera 7 und ein Beleuch tungskasten 8 angebracht. Die Videokamera 7 ist an einem Träger 9 befestigt, der mit dem äußeren Gelenkarm 4 verbunden ist. Der Strahlengang O der Videokamera 7 wird mittels eines ebenfalls am Träger 9 befestigten Umlenkspiegels 10 zu einer Betrachtungsstelle gelenkt, die das vom Greifer 5 erfaßte Bauelement 11 während seiner Bewegung in z-Richtung durchläuft. Vorzugsweise ist der Umlenkspiegel 10 so angeordnet, daß sich das zu vermessende Bauelement 11, beispielsweise die Anschlußdrähte 11a eines elektronischen Bauelementes 11, gerade in der Mitte des Bildfeldes der Videokamera 7 befinden, wenn der Greifer 5 seine oberste voll eingefahrene Stellung einnimmt.

Der Beleuchtungskasten 8 ist an einer von der Videokamera 7 bzw. vom Umlenkspiegel 10 aus gesehen hinter dem Greifer 5 und dem davon erfaßten Bauelement 11 gelegenen Stelle angeordnet. Er ist an einem Träger 12 angebracht, der ebenfalls am äußeren Gelenkarm 4 befestigt ist. Die Oberfläche 12a des Trägers 12 bildet für die Videokamera 7 einen mitbewegten Hintergrund, so daß dort beispielsweise Meßmarken für das Bauelement 11 angebracht werden können.

An der Oberfläche des Trägers 12 ist eine Durchtrittsöffnung 12b für das Licht einer Lichtquelle 14 ausgebildet, die mit einer entsprechenden Durchtrittsöffnung des Lichtkastens 8 fluchtet. Das Licht der Lichtquelle 14 wird mittels eines optischen Kondensors 13 auf die Betrachtungsstelle für das Bauelement 11 konzentriert. Die Anschlußdrähte 11a des Bauelementes 11 erscheinen dadurch in der Videokamera 7 als scharf begrenzter Schattenriß.

Die Drehung des Greifers 5 um seine Achse wird von der Steuereinheit in der Weise gesteuert, daß die Anschlußdrähte 11a aus zwei um 90° gegeneinander verdrehten Richtungen vermessen werden. Um diese Vermessung in der für das Verschieben des Greifers zum Bestückungspunkt ohnehin erforderlichen Taktzeit vor sich gehen zu lassen, wird die Bewegung der Gelenkarme 3 und 4 von der Bewegung des Greifers 5 entkoppelt. Die Greiferbewegung wird in eine solche Anzahl von vorzugsweise etwa gleich großen Teilbewegungen zerlegt, wie sie erforderlich sind, um das Bauelement 11 während der Bewegung des Greifers 5 aus der Bereitstellungsposition in die Bestückungsposition aus der bei der Bereitstellung eingenommenen Winkellage in die zur Vermessung erforderlichen beiden 90°-Winkellagen und anschließend in die für die Bestückung erforderliche Winkellage zu überführen und das Bauelement anschließend auf die Leiterplatte abzusenken. Für die Vermessung von Bauelementen mit nur zwei Anschlußdrähten 11a genügt im allgemeinen die Vermessung in nur zwei verschiedenen Winkelstellungen von beispielsweise 90°. Für elektronische Bauelemente mit mehreren abstehenden Anschlußdrähten kann es jedoch zweckmäßig sein, die Vermessung unter mehreren verschiedenen Winkelstellungen durchzuführen. Die erfindungsgemäße Vorrichtung ist auch für Roboter geeignet, die um mehr als drei Achsen verstellbar sind und die beispielsweise auch das schräge Einsetzen von Bauelementen ermöglichen. In letzterem Falle ist sogar das Einsetzen von Bauelementen in vorbestimmter Schrägstellung in die Leiterplatte möglich.

## Ansprüche

1. Vorrichtung zum maschinellen Bestücken von Leiterplatten mit Bauelementen (11), bei welcher die Bauelemente mittels eines Greifers (5), der am äußeren Gelenkarm (4) eines Roboters angebracht ist, von ihrer Bereitstellungsposition zur Bestückungsposition transportierbar und dort in die Leiterplatte einsetzbar sind, mit einer Vermessungseinrichtung (7) zum optischen Vermessen der Bauelemente (11) während ihres Transportes von der Bereitstellungsposition zur Bestückungsposition, wobei das Vermessungsergebnis in die programmierbare Steuereinrichtung des Roboters eingegeben und in dieser bei der Bestückung berücksichtigt wird, dadurch **gekennzeichnet,** daß die Vermessungseinrichtung (7) in unmittelbarer Zuordnung zum Bewegungsbereich des vom Greifer (5) erfaßten Bauelementes (10) am äußeren Roboterarm (4) so angebracht ist, daß das Bauelement während seines Transportes von der Bereitstellungsposition zur Bestückungsposition von der Seite aus bezogen auf die Drehachse (A3) des Greifers (5) in mindestens zwei unterschiedlichen Winkelstellungen vermessen wird.

2. Vorrichtung nach Anspruch 1, dadurch **gekennzeichnet,** daß die Vermessungseinrichtung (7) seitlich neben dem Verschiebeweg des Greifers (5) angeordnet ist und die Vermessung des Bauelementes (11) in seinen unterschiedlichen Winkelstellungen durch Verdrehen des Greifers (5) um seine Drehachse (A3) erfolgt, wobei die Steuerung dieser Drehbewegung des Greifers (5) unabhängig von der Steuerung der Bewegung der Roboterarme (3,4) für den Transport des Bauelementes erfolgt.

3. Vorrichtung nach Anspruch 1 oder 2, dadurch **gekennzeichnet,** daß die Vermessungseinrichtung (7) so am äußeren Gelenkarm (4) des Roboters angebracht ist, daß ihr Vermessungsfeld demjenigen Bereich zugeordnet ist, den das Bauelement (11) in der voll eingefahrenen Stellung des Greifers (5) einnimmt.

4. Vorrichtung nach einem der vorhergehenden Ansprüche, dadurch **gekennzeichnet,** daß die unabhängige Drehbewegungssteuerung des Greifers (5) zum Vermessen des Bauelementes so erfolgt, daß der Greifer in vorzugsweise annähernd gleichen Zeitabschnitten aus seiner Stellung in der Bereitstellungsposition über die gewünschten unterschiedlichen Vermessungs-Winkelstellungen bis in die vorbestimmte Stellung in der Bestückungsposition verdreht wird.

5. Vorrichtung nach einem der vorhergehenden Ansprüche, dadurch **gekennnzeichnet,** daß am äußeren Gelenkarm (4) eine von der Vermessungseinrichtung (7) aus gesehen hinter dem Bewegungsbereich des Bauelementes (11) angeordnete und damit direkt in die Vermessungseinrichtung (7) strahlende Lichtquelle (13,14) angeordnet ist.

6. Vorrichtung nach einem der vorhergehenden Ansprüche, dadurch **gekennnzeichnet,** daß am äußeren Gelenkarm (4) eine von der Vermessungseinrichtung (7) aus gesehen hinter dem Bewegungsbereich des Bauelementes (11) angeordnet optischer Hintergrund (12a) angebracht ist.

7. Vorrichtung nach einem der vorhergehenden Ansprüche, dadurch **gekennnzeichnet,** daß die optische Achse (O) der Vermessungseinrichtung (7) parallel zur Drehachse (A3) des Greifers (5) angeordnet ist und der Strahlengang der Vermessungseinrichtung (7) mittels eines Umlenkspiegels (10) in Richtung des Bewegungsbereiches des Bauelementes (11) seitlich umgelenkt ist.

8. Vorrichtung nach einem der vorhergehenden Ansprüche, dadurch **gekennnzeichnet,** daß als Vermessungseinrichtung eine Videokamera (7) benutzt ist, deren optische Achse (O) parallel zur Drehachse (A3) des Greifers angeordnet und mittels eines Umlenkspiegels (10) in Richtung des Bewegungsbereiches des Bauelementes (11) seitlich umgelenkt ist, und gegenüber dem Umlenkspiegel (10) hinter dem Bewegungsbereich des Bauelementes (11) die Lichtquelle (13,14) angeordnet ist.

A1　　A2　A3

4

6

3

2

2a

5

1

z

x

y

Fig. 1

Fig. 2